# EUROPEAN PATENT APPLICATION

(11) **EP 1 020 927 A1**
(43) Date of publication of application: **19.07.2000**
(21) Application number: 00300059.3
(22) Date of filing: 06.01.2000
(51) Int. Cl.: H01L 29/92, H01L 27/108, H01L 27/06

(54) **Thin film capacitor comprising a barrier layer between a tantalum pentoxide layer and a copper layer**

(30) Priority: 13.01.1999 US 115688 P; 31.08.1999 US 387155
(71) Applicant: LUCENT TECHNOLOGIES INC., Murray Hill, New Jersey 07974-0636 (US)
(72) Inventor: Merchant, Sailesh M., Orlando, Florida 32835 (US); Oh, Minseok, Orlando, Florida 32836 (US); Roy, Pradip K., Orlando, Florida 32819 (US); Wong, Yiu-Hue, Summit, New Jersey 07901 (US)
(74) Representative: Johnston, Kenneth Graham

(57) **Abstract**

The present invention provides for an integrated circuit metal-oxide-metal ("MOM") capacitor that has a first electrode (110), a tantalum pentoxide layer (120) formed over the first electrode, a barrier layer (130) formed on the tantalum pentoxide layer, and a second electrode (140) comprising copper and formed on the first barrier layer. In one embodiment, the first barrier layer of the MOM capacitor is made of tantalum nitride. A further barrier layer (210) may furthermore be disposed between the tantalum pentoxide layer and the first electrode.

## Description

### Cross Reference To Provisional Application

This application claims the benefit of U.S. Provisional Application, Inventor-Case No. 49-5-69-41, entitled "Mom Structure Using Cu/TaN/Ta₂O₅," to Merchant, *et. al.,* filed on January 13, 1999, which is commonly assigned with the present invention and incorporated herein by reference as if reproduced herein in its entirety.

### Technical Field Of The Invention

he present invention is directed, in general, to a semiconductor device and, more specifically, to a metal-oxide-metal capacitor having a copper-tantalum nitride-tantalum pentoxide stack and a method of manufacturing the same.

### Background Of The Invention

The trend in semiconductor chips is for more components to be incorporated in the semiconductor chip in order to satisfy customer demand for increased chip performance. The demand for increased packing density and chip functionality and performance, combined with smaller chip sizes, has been answered in part by the incorporation of copper into device and interconnect structures. Copper is particularly desirable because copper provides lower resistance, faster devices and better electromigration. Further, to limit the number of levels and reduce the width and spacing of metals, copper, instead of aluminum, is an attractive alternative.

Notwithstanding the benefits of using copper, however, copper presents its own set of unique problems. One such problem is that copper defuses very rapidly in both oxide and silicon. If unblocked, copper atoms can reach the silicon area of a chip and destroy devices, thereby causing severe drift problems and junction leakage. In order to prevent copper from reaching the silicon areas and destroying devices, protective measures must be taken within the device to contain the copper. This problem needs to be specifically addressed in the case of metal-oxide-metal capacitors. If the metal layers are copper and the center layer is an oxide dielectric, such as tantalum pentoxide, the copper will alloy with the dielectric at the oxide metal interface and degrade the capacitor.

Therefore, what is needed in the art is a method to isolate the copper layers in a metal-oxide-metal capacitor without degrading the device.

### Summary Of The Invention

To address the above-discussed deficiencies of the prior art, the present invention provides for an integrated circuit metal-oxide-metal ("MOM") capacitor that has a first electrode, a tantalum pentoxide layer formed on the first electrode, a first barrier layer formed on the tantalum pentoxide layer, and a second copper electrode formed on the first barrier layer. In one embodiment, the first barrier layer of the MOM capacitor is tantalum nitride.

Thus in broad scope, the present invention provides for a MOM capacitor with tantalum pentoxide forming the oxide layer and copper forming one of the electrodes. In order to prevent the copper electrode from degrading the capacitor, the invention provides for a barrier layer to be formed between the tantalum pentoxide layer and the copper electrode.

In one embodiment of the invention, the MOM capacitor has a copper first electrode with a second barrier layer formed on the first electrode. Another aspect of a MOM capacitor with a copper first electrode provides for a tantalum nitride second barrier layer. In yet another embodiment, the MOM capacitor has a titanium first electrode with a second barrier layer formed on the first electrode. In yet another aspect of a MOM capacitor with a titanium first electrode, the invention provides for a titanium nitride second barrier layer. In yet another embodiment, the first electrode of the MOM capacitor is doped polysilicon. A MOM capacitor with the first electrode comprised of aluminum, aluminum/silicon/copper or aluminum/copper alloy is another embodiment of the present invention.

The invention also provides for a semiconductor device, to be illustrated and described herein, comprising active devices located on a semiconductor substrate with a metal-oxide-metal capacitor electrically connected to at least one of the active devices. The capacitor has a first electrode formed over the semiconductor substrate, a tantalum pentoxide layer formed on the first electrode, a first barrier layer formed on the tantalum pentoxide layer, and a second electrode of copper formed on the first barrier layer.

The foregoing has outlined, rather broadly, preferred and alternative features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention. Those skilled in the art should also realize that such equivalent constructions do not depart from the spirit and scope of the invention in its broadest form.

### Brief Description Of The Drawings

For a more complete understanding of the present invention, reference is now made to the following descriptions taken in conjunction with the accompanying drawings, in which:
FIGURE 1 illustrates a metal-oxide-metal (MOM) capacitor constructed in accordance with the present invention;
FIGURE 2 illustrates an embodiment of the present invention where both the first electrode and the second electrode of the MOM capacitor are copper;
FIGURE 3 illustrates a semiconductor device with several active devices located on a substrate with one of the devices electrically connected to a MOM capacitor; and
FIGURE 4 illustrates an embodiment of one method to manufacture an integrated circuit MOM capacitor on a semiconductor wafer.

### Detailed Description

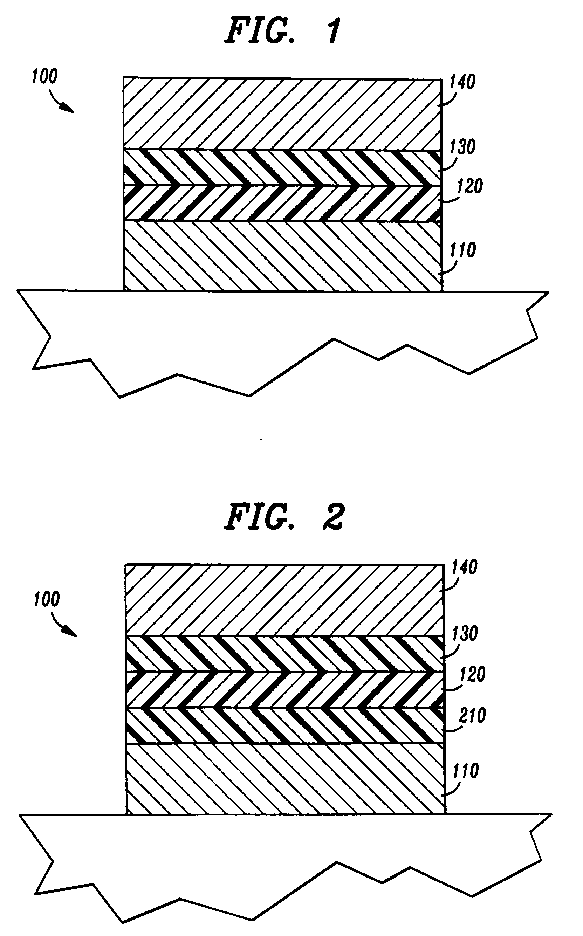

Referring initially to FIGURE 1, illustrated is an exemplary embodiment of a metal-oxide-metal (MOM) capacitor 100 constructed in accordance with the present invention. The MOM capacitor 100 has a first electrode 110, over which is formed the dielectric oxide layer 120 of, in this instance, tantalum pentoxide. In this embodiment, the second electrode 140 is copper and the first electrode 110 is a metal does not diffuse through the dielectric oxide layer 120. The first electrode 110 and the dielectric oxide layer 120 may be deposited by conventional methods, such as physical vapor deposition (PVD) or chemical vapor deposition (CVD).

As previously noted, when copper is used as the second electrode 140 and is in direct contact with the oxide layer 120, the copper will alloy at the interface between the two layers and diffuse through the dielectric layer 120. For this reason, a protective barrier layer 130 is formed on top the tantalum pentoxide dielectric layer 120 in order to isolate the tantalum pentoxide dielectric layer 120 from the copper second electrode 140. Again, the barrier layer 130 may be deposited by conventional processes as those mentioned above.

While any number of materials could be used to form the barrier layer 130, a particularly favorable embodiment of the present invention calls for a tantalum nitride barrier layer 130. As thus constructed, the tantalum nitride barrier layer 130 will prevent the copper layer 140 and the tantalum pentoxide layer 120 from reacting at an interface that would otherwise be present between the two layers, which could cause the MOM capacitor 100 to degrade.

Turning now to FIGURE 2, illustrated is an embodiment of the present invention where both the first electrode 110 and the second electrode 140 of the MOM capacitor 100 are copper. Because both electrodes 110, 140 are copper, a second barrier layer 210 must be formed between the copper first electrode 110 and the tantalum pentoxide dielectric layer 120. This is required for the same reason as set forth above; that is, the barrier layer 210 is required in order to prevent the copper first electrode 110 from alloying at what would otherwise be an interface between the first electrode 110 and the oxide dielectric 120. A particularly favorable embodiment of the invention again provides for the second barrier layer 210 to be tantalum nitride.

As described thus far, the present invention provides for a MOM capacitor 100, with a tantalum pentoxide dielectric layer 120, and copper electrodes 140, 110. The use of high K materials, such as tantalum pentoxide, as the oxide layer 120, in combination with copper as the electrodes 140, 110 permits the manufacture of a more efficient MOM capacitor. Capacitors of this type are possible if the barrier layer 130and 210 are interposed between the oxide layer 120, and the copper electrodes 140, 210.

Several additional embodiments of the invention are provided for herein that involve other materials for the barrier layers and for the first electrode layer 110. Continuing to refer to FIGURE 2, the first electrode layer 110 may be made from materials known to those who are skilled in the art, such as titanium, a doped polysilicon, aluminum, aluminum/silicon/copper alloy or aluminum/copper alloy . In those instances where the first electrode 110 is titanium, the second barrier layer 210 is titanium nitride.

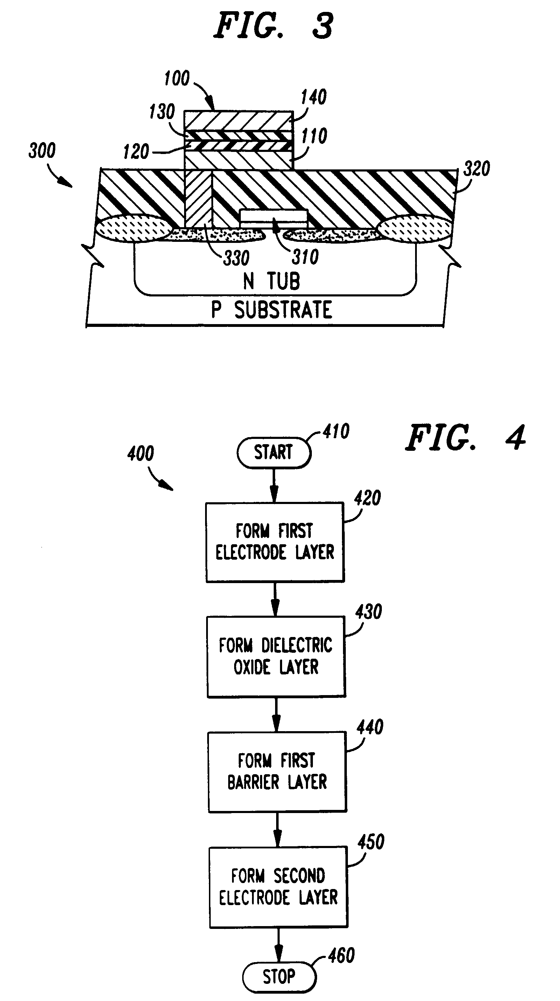

Turning now to FIGURE 3, illustrated is a partial schematics sectional view of a conventionally formed semiconductor device 300 with an active device 310 electrically connected to the MOM capacitor 100. In a preferred embodiment, the active device 310 is a transistor, such as a CMOS transistor, an NMOS transistor, or a PMOS transistor. Further explanation of the operation of the illustrated semiconductor device 300 is not required since those of ordinary skill in the art will readily understand how such devices function. The MOM capacitor 100 is formed on a dielectric substrate 320, such that it is electrically connected to the active device 310 by a contact plug 330.

Turning now to FIGURE 4 with continued reference to FIGUREs 1 and 3, illustrated is a flow chart of one method 400 for manufacturing the MOM capacitor 100 on a dielectric substrate 320 of the semiconductor device 300 illustrated in FIGURE 3. The method 400 commences with a start step 410. Then in step 420, the first electrode layer 110 is conventionally deposited over the dielectric substrate 320. The first electrode layer 110 is deposited such that it contacts the contact plug 330, thereby electrically connecting it to the active device 310. Then, in step 430 the dielectric oxide layer 120 is formed on the first electrode 110. Following the formation of the dielectric oxide layer 120, the barrier layer 130 is formed over the dielectric oxide in step 440. The barrier layer 130 is present in this particular embodiment because the second electrode is copper. Thus, in step 450, the second electrode 140 is deposited over the barrier layer 130. The illustrated embodiment of the manufacturing method concludes with the stop step 460.

Those skilled in the art will readily understand that additional steps may be required to form other embodiments of the invention described herein. For example, if copper is to be used as the first electrode layer, a form second barrier step will be required to provide a protective barrier between the copper first electrode and the tantalum pentoxide oxide layer.

The various steps calling for the deposition of layers can be performed by using either a physical deposition process or a chemical deposition process, which are well known to those who are skilled in the art. Furthermore, those who are skilled in the art also understand how to fabricate the transistor device to which the MOM capacitor may be connected.

Based on the foregoing, it is readily apparent that the present invention provides a MOM capacitor for use with an integrated circuit. The MOM capacitor includes a first electrode, a tantalum pentoxide layer formed on the first electrode, a first barrier layer formed on the tantalum pentoxide layer, which is a tantalum nitride, and a second copper electrode formed on the first barrier layer. The barrier layer prevents the copper electrode from diffusing through the tantalum pentoxide layer and thereby degrading the capacitor.

Although the present invention has been described in detail, those skilled in the art should understand that they can make various changes, substitutions and alterations herein without departing from the spirit and scope of the invention in its broadest form.

## Claims

1. An integrated circuit metal-oxide-metal capacitor comprising:
a first electrode;
a tantalum pentoxide layer formed on the first electrode;
a first barrier layer formed on the tantalum pentoxide layer; and
a second electrode comprising copper formed on the first barrier layer.

2. The capacitor as recited in Claim 1 wherein the first barrier layer is tantalum nitride.

3. The capacitor as recited in Claim 1 wherein the first electrode is copper and the capacitor further comprises a second barrier layer formed on the first electrode.

4. The capacitor as recited in Claim 3 wherein the second barrier layer is tantalum nitride.

5. The capacitor as recited in Claim 1 wherein the first electrode is titanium and the capacitor further comprises a second barrier layer formed on the first electrode.

6. The capacitor as recited in Claim 5 wherein the second barrier layer is titanium nitride.

7. The capacitor as recited in Claim 1 wherein the first electrode is doped polysilicon.

8. The capacitor as recited in Claim 1 wherein the first electrode is aluminum, aluminum/silicon/copper alloyer or aluminum/copper alloy.

9. A semiconductor device, comprising:
active devices located on a semiconductor substrate;
a metal-oxide-metal capacitor electrically connected to at least one of the active devices, the capacitor having:
a first electrode formed over the semiconductor substrate;
a tantalum pentoxide layer formed on the first electrode;
a first barrier layer formed on the tantalum pentoxide layer; and
a second electrode comprising copper formed on the first barrier layer.

10. The semiconductor device as recited in Claim 9 wherein the first barrier layer of the capacitor is tantalum nitride.

11. The semiconductor device as recited in Claim 9 wherein the semiconductor substrate is a dielectric material.

12. The semiconductor device as recited in Claim 11 wherein the first electrode of the capacitor is copper and further comprising a second barrier layer formed on the first electrode.

13. The semiconductor device as recited in Claim 9 wherein the second barrier layer of the capacitor is tantalum nitride.

14. The semiconductor device as recited in Claim 13 wherein the first electrode of the capacitor is titanium and further comprising a second barrier layer formed on the first electrode.

15. The semiconductor device as recited in Claim 9 wherein the second barrier layer of the capacitor is titanium nitride.

16. The semiconductor device as recited in Claim 9 wherein the first electrode of the capacitor is doped polysilicon.

17. The semiconductor device as recited in Claim 9 wherein the first electrode of the capacitor is aluminum, aluminum/silicon/copper alloy or aluminum copper alloy.

18. The semiconductor device as recited in Claim 9 wherein the active devices are transistors.

19. The semiconductor device as recited in Claim 9 wherein
the transistors form a device selected from the group consisting of:
CMOS;
NMOS;
PMOS; and
Bi-Polar devices.
